# EUROPEAN PATENT SPECIFICATION

(11) **EP 0 333 197 B1**
(45) Date of publication and mention of the grant of the patent: **01.09.1993**
(21) Application number: 89104741.7
(22) Date of filing: 16.03.1989
(51) Int. Cl.: G01R 21/08, G06G 7/162

(54) **Supply circuit for a Hall sensor multiplication circuit**
Versorgungsschaltung für eine Hallsonden-Multiplizierungsschaltung
Circuit d'alimentation pour un circuit multiplicateur à sonde de Hall

(30) Priority: 18.03.1988 YU 556/88
(43) Date of publication of application: 20.09.1989
(73) Proprietor: ISKRA STEVCI Industrija merilne in upravljalne tehnike Kranj, d.o.o., SI-64000 Kranj (SI)
(72) Inventor: Rozman, Miro, YU-64248 Lesce (YU)
(74) Representative: Lehn, Werner, Dipl.-Ing.

(56) References cited:
- EP-A- 0 163 460
- DE-A- 3 711 978
- DE-A- 3 723 268
- PATENT ABSTRACTS OF JAPAN, vol. 6, no. 175 (P-141)[1053], 9th September 1982; & JP-A-57 93 263 (TOKYO SHIBAURA DENKI K.K.) 10-06-1982

## Description

### BACKGROUND OF THE INVENTION

### Technical Field

This invention relates to a supply circuit supplying electric current to a Hall sensor multiplication circuit in such a way that the absolute value of the output voltage of the multiplication circuit is changed for about 0.01% at most when the polarity of this output voltage is reversed.

### Description of the Prior Art

In known watthour meters or wattmeters which are based on the Hall effect a multiplication circuit reversing the polarity of the output Hall voltage is used to compensate internal disturbances of the meter. Such meters are described e.g. in DE-A-37 11 978 and DE-A-37 02 344.

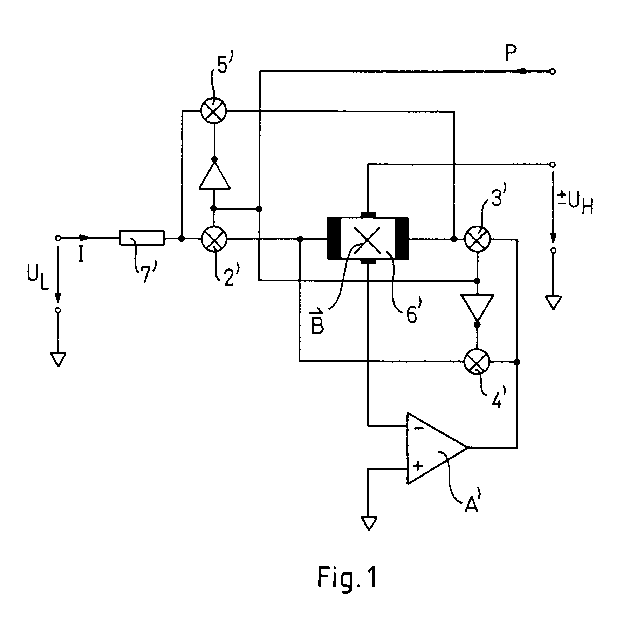

A known multiplication circuit is composed of a Hall sensor 6' whose first voltage terminal is connected to the inverting input of an operational amplifier A', the second terminal, however, is connected to the output of the multiplication circuit, and of a switching bridge which is made of controlled switches 2', 3', 4', 5' and which supplies electric current across a resistor 7' being connected to one terminal of a load to current terminals of the Hall sensor 6' (Fig. 1). A signal P from a voltage to frequency converter controls the polarity of the Hall voltage U_{H} at the multiplication circuit output by exchanging the current terminals of the Hall sensor 6'. The described multiplication circuit performed in a monolithic technology provides good results when the Hall sensor is performed separatedly from the rest of the multiplication circuit. When, however, the Hall sensor is integrated with the rest of the multiplicaiton circuit on a common substrate the accuracy of the polarity reversal of the Hall voltage U_{H} is affected by the nonideally symmetric shape of the Hall sensor as well as by the nonlinearity originating from a barrier layer separating the Hall sensor from the substrate.

EP-A-0 163 460 discloses a system for measuring the electrical energy consumed by a load. The system can be used in an energy meter, or a Watt-meter. The system employs a Hall effect element with supply circuits, and switching means control a relative phase change between the bias current and the magnetic field associated with the Hall effect element to cause thereby a change in the Hall output voltage which is fed to signal processing circuits and measuring circuits to give a measure of the electrical energy consumed, which is independent of errors arising from the self-field effect of the bias current in the Hall effect element.

Electrical energy measuring devices employing Hall effect elements are based on the principle that the Hall effect element produces a Hall output voltage proportional to the product of a bias current passing through the element and a magnetic field applied to the element. The magnitude of the bias current and the strength of the magnetic field are proportional to the load voltage and load current respectively. In such devices one of the problems is that the bias current itself produces a magnetic field which generates an error component in the Hall output voltage, referred to as the self-field effect error term. This error term can result in unacceptable inaccuracies of power measurement. The self-field effect error term is also temperature dependent in a non linear manner which makes correction methods difficult.

EP-A-0 163 460 suggests for eliminating the problems mentioned above, a system for measuring the electrical energy consumed by a load, including a Hall effect element, and supply circuits for the Hall effect element which are responsive to the load voltage and the load current and include a magnetic circuit for applying a magnetic field to the element and a bias current supply circuit, wherein the supply circuits include switching means operable to effect a relative phase shift between the bias current and the magnetic field at predetermined time intervals and thereby change the phase of a self-field effect error component K_{sf} of the Hall output voltage of the element, a processing circuit is connected to the output of the Hall effect element and is operable to generate in different time periods self-cancelling error signals derived from two different switched phases of the self-field effect error component K_{sf}, and a measuring circuit is operable to receive the processed signals and to register a measurement proportional to the true power W and energy consumption of the load.

For removing the influence of an offset voltage of an operational amplifier and an in-phase voltage of a Hall element employed in a Watt-hour meter, PATENTS ABSTRACTS OF JAPAN, vol. 6,, no. 175 (P-141)(1053), September 09, 1982 suggests a method wherein a polarity of a control current applied to the Hall element and an input of a Hall element output to two filters are switched in synchronism with each other.

This prior art method uses a circuit where a load voltage is inputted to a voltage-current conversion circuit via a power transformer, a phase-shifting circuit and a first set of analogue switch groups, and is supplied as a control current to a terminal of the Hall element. Meanwhile, a load current is converted into a magnetic field by a core and is applied to the Hall element. The output of the Hall element is inputted to a V/F converter via a buffer amplification circuit, a second set of analogue switch groups, and low-pass filters. Both sets of analogue switch groups are alternately switched and controlled by means of a pulse of duty ratio 50 % from a pulse generator. This eliminates the need to adjust a light load and permits fetching of a Hall output voltage by means of a high input impedance.

In accordance with the foregoing background discussion the object of this invention is to provide a supply circuit which will supply a Hall sensor multiplication circuit with electric current whose intensity at a current sense reversal caused by a control signal will be changed for only about 0.01 % of its absolute value, the supply circuit and the multiplication circuit, however, must be able to be produced in a monolithic technology on a common substrate.

With the foregoing objects in view, the supply circuit in accordance with the invention comprises the features of claim 1. Claim 2 relates to features of a preferred embodiment of the invention.

A specific embodiment of the invention will be presented in the following detailed description in conjunction with the accompanying drawings.

### BRIEF DESCRIPTION OF THE DRAWINGS

In the drawings,
- Fig. 2: is a graphical illustration of the supply circuit of the invention, and of a Hall sensor multiplication circuit,
- Figs. 3a,b: is a schematic illustration of the supply circuit of the invention and of a negative impedance converter, respectively.

### DETAILED DESCRIPTION OF THE PREFERRED EMBODIMENT

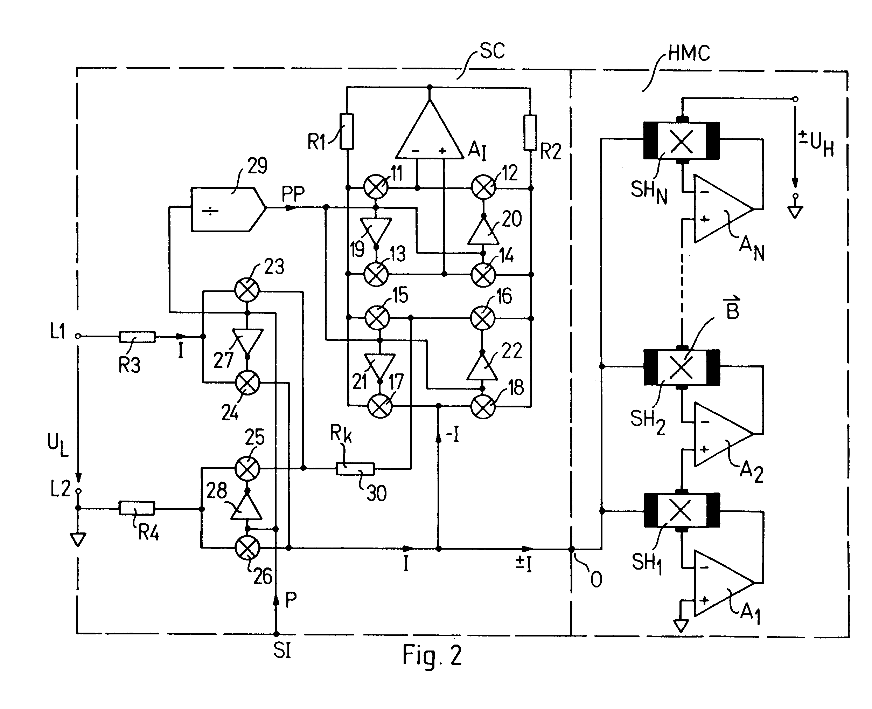

The supply circuit SC in accordance with the invention for supplying electric current to a Hall sensor multiplication circuit HMC is shown in Fig. 2. The output O of the supply circuit SC is connected to the current input of the multiplication circuit HMC. At the output of the multiplication circuit HMC, which is performed by Hall sensors SHⱼ, cascade connected through operational amplifiers Aⱼ, the voltage U_{H} appears.

Load terminals L1,L2 of the supply circuit SC, the load terminal L2 being grounded, are connected to terminals of an external load , whose electric energy or power consumption is measured. Magnetic induction 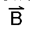 at the Hall sensors SHⱼ is proportional to the electric current through the load causing a voltage drop U_{L} thereon. The terminal L1 is , through a resistor R3 connected, on the one hand through a controlled switch 23 to the first terminal of an adjustable resistor Rk and on the other hand through a controlled switch 24 to the output terminal O of the supply circuit SC. The output terminal O is connected through a controlled switch 26 to the first terminal of a resistor R4 and further through a controlled switch 25 to the first terminal of the resistor Rk . The second terminal of the resistor R4 is connected to the load terminal L2 . The second terminal of the resistor Rk is connected to a common terminal of controlled switches 15,16, the second terminal of these switches being connected to a common terminal of controlled switches 11,13 and 12,14 , respectively, and to the first terminal of a resistor R1 and R2, respectively. The second terminal of the resistors R1,R2 is connected to the output of an operational amplifier A_{I} , which together with the resistors R1,R2 forms a negative impedance converter . The inverting input of the amplifier A_{I} is connected to the second terminal of the switches 11,12 , the noninverting input , however , is connected to the second terminal of the switches 13,14 . The first terminal of the resistors R1,R2 is connected through controlled switches 17 and 18 , respectively , to the output terminal O of the supply circuit SC.

The signal input terminal SI of the circuit SC is connected to the control terminal of the switches 23,26 and to the input of a frequency divider 29, and through inverters 27,28 to the control terminal of the switches 24 and 25 ,respectively . The output of the divider 29 is connected to the control terminal of the switches 11,14,15,18 , and through inverters 19,20,21,22 to the control terminal of the switches 13,12,17,16, respectively.

The resistances of the resistors R1,R2 are equal , the resistance of the resistor Rk equals the doubled resistance of the load at the output O of the supply circuit SC.

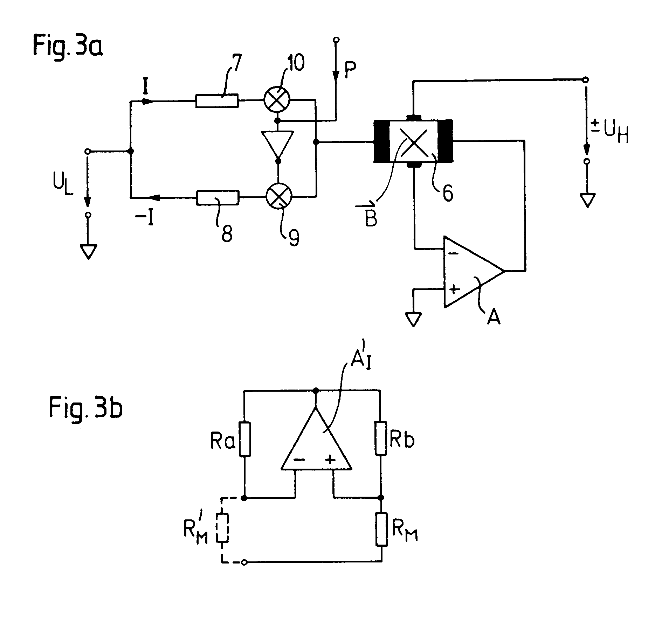

For the moment the operation of the supply circuit SC in accordance with the invention will be represented schematically with Figs. 3a,b . Alternately through the switches 9,10 the current -I and +I , respectively , is supplied to the multiplication circuit which is composed of a Hall sensor 6 and of an operational amplifier A (Fig. 3a). Resistors 7,8 symbolically represent oppositely equal resistances with an absolute value equal to the equivalent resistance of both the supply circuit and the multiplication circuit.

A negative impedance converter (Fig. 3b) composed of an operational amplifier A_{I}' and of resistors Ra,Rb transforms the resistance R_{M} at the output into the resistance ${\text{R}}_{\text{M}} {\text{'=-R}}_{\text{M}} \text{.Ra/Rb}$ at the input if the resistors Ra,Rb are connected as represented in Fig. 3b, and into the resistance ${\text{R}}_{\text{M}} {\text{'=-R}}_{\text{M}} \text{.Rb/Ra}$ 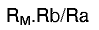 if the resistors in Fig. 3b are mutually interchanged. If this interchanging is performed by a control signal P periodically with realisation times of both configurations being equal then the input resistance is averaged to ${\text{R}}_{\text{M,av}} {\text{'=-(Ra/Rb + Rb/Ra).R}}_{\text{M}} \text{/2}$ 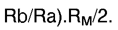 . Supposing that in monolithic technology two resistors with equal resistances differing for 1% can be made , it follows from the last expression that the relation R_{M}'=-R_{M} is realizable with an accuracy of 0,01%.

At the output O of the circuit SC there flows the supply current ${\text{I=U}}_{\text{L}} {\text{/(R3 + R}}_{\text{M}} \text{)}$ when the signal P at the input SI is logic 0 ; here by R_{M} the resistance of the multiplication circuit HMC connected to the output O is meant . When the signal P is logic 1 the supply current is ${\text{I=-U}}_{\text{L}} {\text{/(R3 + Rk-R}}_{\text{M}} \text{)}$ 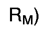 and its absolute value equals the absolute value of the former supply current if it is set ${\text{Rk = 2R}}_{\text{M}}$ 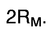 . With a signal PP appearing at the output of the frequency divider 29 the mutual interchanging of the resistors R1,R2 in the negative impedance converter is controlled.

A parasitic current originating from the offset voltage of the operational amplifier A_{I} is conducted to a mass through the resistor R4 . The parasitic current is compensated most completely when the resistances of the resistors R3,R4 are equal.

The advantage of the circuit according to the invention exists in that the absolute value of the output voltage of the Hall sensor multiplication circuit integrated in a monolithic technology on a common substrate with the supply circuit is preserved with an accuracy of 0,01% at the polarity reversal of this voltage.

## Claims

1. Supply circuit for a Hall sensor multiplication circuit, characterized in that a load terminal (L1) is connectable through a first resistor (R3), at one hand through a first controlled switch (23) to the first terminal of an adjustable resistor (Rk), and at the other hand through a second controlled switch (24) to the output terminal (O) and through a third controlled switch (26) to the first terminal of a second resistor (R4), whose second terminal is connected to a grounded load terminal (L2), the first terminal of the second resistor (R4) being connectable through a fourth controlled switch (25) to the first terminal of the adjustable resistor (Rk),
that the second terminal of the adjustable resistor (R4) is connected to a common terminal of fifth and sixth controlled switches (15, 16),
that the second terminal of the fifth controlled switch (15) is connected to the common terminal of seventh and eigth controlled switches (11, 13) and to the first terminal of a third resistor (R1),
that the second terminal of the sixth controlled switch (16) is connected to the common terminal of ninth and tenth controlled switches (12, 14) and to the first terminal of a fourth resistor (R2),
that the second terminals of the third and fourth resistors (R1, R2) are connected to the output of an operational amplifier (A₁), whose inverting input is connected to the second terminal of the seventh and ninth controlled switches (11, 12) and whose noninverting input is connected to the second terminal of the eigth and tenth controlled switches (13, 14),
that the output terminal (O) is connectable through eleventh and twefth controlled switches (17, 18) to the first terminals of the third and fourth resistors (R1, R2, resp.),
that the signal input terminal (SI) is connected to the control terminals of the first and third controlled switches (23, 26), and through inverters (27, 28) to the control terminals of the second and fourth controlled switches (24, 25, resp.) and to the input of a frequency divider (29),
that the output of the frequency divider (29) is connected to the control terminals of the seventh, tenth, fifth and twelfth controlled switches (11, 14, 15, 18),
and that the output of the frequency divider (29) is connected, through an inverter (19) to the control terminal of the eigth controlled switch (13), through an inverter (20) to the control terminal of the ninth controlled switch (12), through an inverter (21) to a control terminal of the eleventh controlled switch (17), and through an inverter (22) to the control terminal of the sixth controlled switch (16).

2. Supply circuit according to claim 1, characterized in that the resistances of the third and fourth resistors (R1, R2) are equal and the resistance of the adjustable resistor (Rk) equals the doubled resistance of the load at the circuit output (O).

## Patentansprüche

1. Speisestromkreis für eine Multiplikationsschaltung mit Hall-Sensoren, gekennzeichnet dadurch,
daß eine Last-Klemme (L1) über den ersten Widerstand (R3) einerseits über den ersten gesteuerten Schalter (23) an die erste Klemme eines einstellbaren Widerstandes (Rk) und andererseits über den zweiten gesteuerten Schalter (24) an die Ausgangsklemme (O) und über den dritten gesteuerten Schalter (26) an die erste Klemme des zweiten Widerstandes (R4), dessen zweite Klemme an eine an Masse angeschlossene Lastklemme (L2) angeschlossen ist, und die erste Klemme des vierten Widerstandes (R4) über den vierten gesteuerten Schalter (25) an die erste Klemme des einstellbaren Widerstandes (Rk) angeschlossen sind,
daß die zweite Klemme des einstellbaren Widerstandes (Rk) an die gemeinsame Klemme des fünften und sechsten gesteuerten Schalters (15, 16) angeschlossen ist,
daß die zweite Klemme des fünften gesteuerten Schalters (15) an die gemeinsame Klemme des siebten und achten gesteuerten Schalters (11, 13) und an die erste Klemme des dritten Widerstandes (R1) angeschlossen ist,
daß die zweite Klemme des sechsten gesteuerten Schalters (16) an die gemeinsame Klemme des neunten und zehnten gesteuerten Schalters (12, 14) und an die erste Klemme des vierten Widerstandes (R2) angeschlossen ist,
daß die zweiten Klemmen des dritten und des vierten Widerstandes (R1, R2) an den Ausgang eines Operationsverstärkers (A_{I}) angeschlossen sind, dessen invertierender Eingang an die zweite Klemme des siebten und des neunten gesteuerten Schalters (11, 12) und dessen nichinvertierender Eingang an die zweite Klemme des achten und zehnten gesteuerten Schalters (13, 14) angeschlossen sind,
daß die Ausgangsklemme (O) durch den elften und zwölften gesteuerten Schalter (17, 18) an die ersten Klemmen des dritten und des vierten Widerstandes (R1 bzw. R2) angeschlossen ist,
daß die Signaleingangsklemme (SI) an die Steuerklemmen des ersten und des dritten gesteuerten Schalters (23, 26) und über Inverter (27, 28) an die Steuerklemmen des zweiten und des vierten gesteuerten Schalters (24 bzw. 25) und an den Eingang eines Frequenzteilers (29) angeschlossen ist,
daß der Ausgang des Frequenzteilers (29) an die Steuerklemmen des siebten, zehnten, fünften und zwölften gesteuerten Schalters (11, 14, 15, 18) angeschlossen ist,
und daß der Ausgang des Frequenzteilers (29) über einen Inverter (19) an die Steuerklemme des achten gesteuerten Schalters (13) und über einen Inverter (20) an die Steuerklemme des neunten gesteuerten Schalters (12) und über einen Inverter (21) an die Steuerklemme des elften gesteuerten Schalters (17) und über einen Inverter (22) an die Steuerklemme des sechsten gesteuerten Schalters (16) angeschlossen ist.

2. Speisestromkreis nach Patentanspruch 1, gekennzeichnet dadurch,
daß die Widerstände des dritten und des vierten Widerstandes (R1, R2) gleich sind und der Widerstand des einstellbaren Widerstandes (Rk) dem zweifachen Lastwiderstand am Schaltungsausgang (O) gleich ist.

## Revendications

1. Circuit d'alimentation pour circuit multiplicateur destiné à un capteur à effet Hall, caractérisé en ce qu'une borne de charge (L1) peut être reliée par l'intermédiaire d'une première résistance (R3), d'une part, à la première borne d'une résistance ajustable (Rk), par l'intermédiaire d'un premier contacteur commandé (23) et, d'autre part, à la borne de sortie (O), par l'intermédiaire d'un second contacteur commandé (24), et à la première borne d'une seconde résistance (R4), par l'intermédiaire d'un troisième contacteur commandé (26), la seconde borne de cette résistance (R4) étant reliée à une borne de charge mise à la masse (L2), la première borne de la seconde résistance (R4) pouvant être reliée à la première borne de la résistance ajustable (Rk), par l'intermédiaire d'un quatrième contacteur commandé (25),
en ce que la seconde borne de la résistance ajustable (Rk) est reliée à une borne commune d'un cinquième et d'un sixième contacteur commandé (15, 16),
en ce que la seconde borne du cinquième contacteur commandé (15) est reliée à la borne commune d'un septième et d'un huitième contacteur commandé (11, 13) et à la première borne d'une troisième résistance (R1),
en ce que la seconde borne du sixième contacteur commandé (16) est reliée à la borne commune d'un neuvième et d'un dixième contacteur commandé (12, 14) et à la première borne d'une quatrième résistance (R2),
en ce que la seconde borne de la troisième résistance (R1) et celle de la quatrième résistance (R2) sont reliées à la sortie d'un amplificateur opérationnel (A₁) dont l'entrée inversante est reliée à la seconde borne du septième et du huitième contacteur commandé (11, 12) et dont l'entrée non inversante est reliée à la seconde borne du huitième et du dixième contacteur commandé (13, 14),
en ce que la borne de sortie (O) peut être reliée par l'intermédiaire d'un onzième et d'un douzième contacteur commandé (17, 18) à la première borne de la troisième et de la quatrième résistance (R1, R2),
en ce que la borne d'entrée du signal (SI) est reliée à la borne de commande du premier et du troisième contacteur commandé (23, 26), et par l'intermédiaire d'inverseurs (27, 28) à la borne de commande du second et du quatrième contacteur commandé (24, 25), ainsi qu'à l'entrée d'un diviseur de fréquences (29),
en ce que la sortie du diviseur de fréquences (29) est reliée à la borne de commande du septième, du dixième, du cinquième et du douzième contacteur commandé (11, 14, 15, 18), et
en ce que la sortie du diviseur de fréquences (29) est reliée par l'intermédiaire d'un inverseur (19) à la borne de commande du huitième contacteur commandé (13), par l'intermédiaire d'un inverseur (20) à la borne de commande du neuvième contacteur commandé (12), par l'intermédiaire d'un inverseur (21) à la borne de commande du onzième contacteur commandé (17), et par l'intermédiaire d'un inverseur (22) à la borne de commande du septième contacteur commandé (16).

2. Circuit d'alimentation selon la revendication 1, caractérisé en ce que la troisième et la quatrième résistance (R1, R2) sont de valeur égale et en ce que la valeur de la résistance ajustable (Rk) vaut le double de celle de la charge à la sortie (O) du circuit.
